# FASCICULE DE BREVET EUROPEEN

(11) **EP 4 075 528 B1**
(45) Date de publication et mention de la délivrance du brevet: **06.11.2024**
(21) Numéro de dépôt: 22176626.4
(22) Date de dépôt: 25.02.2020
(51) Int. Cl.: H03H 3/02, H03H 9/02, H03H 9/17, H10N 30/01, H10N 30/073

(54) **PROCEDE DE REALISATION D'UN SYSTEME MICRO-ELECTRO-MECANIQUE REALISE A PARTIR D'UNE COUCHE PIEZOELECTRIQUE OU FERROELECTRIQUE REPORTEE**
VERFAHREN ZUR HERSTELLUNG EINES MIKRO-ELEKTRO-MECHANISCHEN SYSTEMS AUS EINER AUFGETRAGENEN PIEZOELEKTRISCHEN ODER FERROELEKTRISCHEN SCHICHT
METHOD FOR PRODUCING A MICRO-ELECTRO-MECHANICAL SYSTEM MADE FROM AN ADDED PIEZOELECTRIC OR FERROELECTRIC LAYER

(30) Priorité: 05.03.2019 FR 1902226
(43) Date de publication de la demande: 19.10.2022
(62) Demande divisionnaire de: 20159234.2
(73) Titulaire: Commissariat à l'Energie Atomique et aux Energies Alternatives, 75015 Paris (FR); Université de Franche-Comté, 25030 Besançon Cedex (FR); École Nationale Supérieure de Mécanique et des Microtechniques, 25030 Besançon Cedex (FR)
(72) Inventeur: REINHARDT, Alexandre, 38054 GRENOBLE Cedex 09 (FR); BOUSQUET, Marie, 38054 GRENOBLE Cedex 09 (FR); BARTASYTE, Ausrine, 25870 LE DUC (FR)
(74) Mandataire: Atout PI Laplace

(56) Documents cités:
- EP-A1- 2 464 006
- EP-A1- 3 714 544
- WO-A1-2011/042388
- US-A1- 2013 249 648
- REINHARDT ALEXANDRE ET AL: "Acoustic filters based on thin single crystal LiNbO3 films: Status and prospects", 2014 IEEE INTERNATIONAL ULTRASONICS SYMPOSIUM, IEEE, 3 September 2014 (2014-09-03), pages 773 - 781, XP032667287, DOI: 10.1109/ULTSYM.2014.0191

## Description

### Domaine technique de l'invention

Le domaine de l'invention est celui des systèmes micro-électro-mécaniques (MEMS, pour *Micro-Electro-Mechanical Systems)* piézoélectriques utilisés comme éléments de traitement de l'information (résonateurs, filtres, ...), comme capteurs (capteurs physiques de température, de pression, d'accélération, de champ magnétique, d'espèces chimiques, ...) ou comme actionneurs (micro-pompes pour systèmes micro-fluidiques, micro-miroirs déformables, ...).

### Etat de l'art

Les composants électromécaniques forment une classe à part de composants utilisés dans des systèmes variés. Ces éléments permettent par exemple de générer des déplacements mécaniques sous l'action d'un signal électrique : on parle alors d'actionneurs. Les exemples les plus répandus de ces composants sont les têtes d'impression d'imprimantes jet d'encre, les injecteurs de carburant utilisés dans l'automobile, ou des systèmes de micro- ou nano-positionnement utilisés en mécanique de précision ou pour l'appareillage scientifique. A l'inverse, d'autres systèmes utilisent la sensibilité d'éléments mécaniques à différents stimuli pour fournir une information électrique permettant de quantifier ceux-ci. On parle alors de capteurs. Les exemples les plus répandus sont dans ce cas des systèmes d'accéléromètres, de gyromètres, de capteurs de pression (microphones), ou autres. Enfin, une dernière catégorie utilise les deux effets simultanément : une structure mécanique est mise en vibration sous l'influence d'un signal électrique périodique ; si la vibration de cette structure mécanique est suffisamment stable, la transcription de cette vibration dans le domaine électrique permet de réaliser un système oscillant stable. On parle alors de résonateur. Les exemples les plus courants de ces composants sont les résonateurs à quartz utilisés dans l'horlogerie ou les oscillateurs utilisés pour la synchronisation temporelle de circuits électriques.

Tous ces systèmes électromécaniques reposent sur la capacité de transduction de la structure, c'est-à-dire à la capacité de transformer un signal issu d'un domaine (électrique, mécanique, ...) en un autre (électrique, mécanique, ...). Plusieurs techniques sont connues, mais l'une des plus courantes est l'utilisation de matériaux piézoélectriques. La piézoélectricité, découverte en 1880 par les frères Curie (P. Curie, Notice sur les travaux scientifiques de M.P. Curie, Gauthier-Villars (1902)) est la capacité d'un cristal à se polariser sous l'action d'une contrainte mécanique, ou réciproquement de se déformer sous l'action d'une tension électrique. Les matériaux piézoélectriques permettent donc d'assurer une transduction électromécanique, ou mécano-électrique.

Les premiers travaux sur les composants piézoélectriques ont utilisé des cristaux naturels, tels que le quartz ou le sel de Rochelle. Ces matériaux ont immédiatement trouvé des applications dans la fabrication de résonateurs, et dans les premiers systèmes de sonars. Pour cette dernière application, néanmoins, les propriétés piézoélectriques de ces matériaux se sont avérées trop faibles pour permettre la génération de fortes pressions dans l'eau, ou à l'inverse la détection de faibles pressions acoustiques. La recherche s'est donc portée sur la synthèse de matériaux artificiels, le plus utilisé d'entre eux étant encore à l'heure actuelle le titanate-zirconate de plomb (PbZrₓTi₁₋ₓO₃, ou PZT) et ses dérivés. La forte piézoélectricité de ce matériau a permis le développement des systèmes de sonars utilisés pour le transport maritime ou la défense, des sondes échographiques utilisées pour le diagnostic médical, des injecteurs de carburants utilisés dans l'automobile, ou encore d'éléments sensibles pour les systèmes de contrôle non-destructifs. Malgré ses excellentes propriétés piézoélectriques, ce matériau présente quelques inconvénients majeurs : étant un composé à base de plomb, sa synthèse, son recyclage et son abandon dans la nature posent des problèmes de toxicité environnementale. De ce fait, les normes telles que RoHS (*Restriction of the use of Hazardous Substances in electronic equipment*) et la directive européenne WEEE (*Waste Electrical and Electronic Equipment*) tendent à interdire sur le long terme son utilisation. De plus, bien que ce matériau présente de fortes propriétés piézoélectriques à basses fréquences, ses pertes électriques et/ou mécaniques sont rédhibitoires pour des applications à hautes fréquences. Enfin, ce matériau perd ses propriétés piézoélectriques à haute température. La recherche s'est donc tournée vers des matériaux alternatifs, tels que le niobate ou le tantalate de lithium (LiNbO₃, LiTaO₃), le niobate de potassium (KNbO₃) et ses dérivés tels que les KNa₁₋ₓNbₓO₃, le titanate de baryum (BaTiO₃) et ses dérivés tels que le (Ba₁₋ₓCaₓ)(Ti_{1-y}Zr_{y})O₃, les titanates de bismuth et de sodium (Na_{0,5}Bi_{0,5}TiO₃) ou autres matériaux exotiques tels que la langasite, la langatate ou leurs dérivés (La₃Ga₅SiO₁₄, La₃Ga_{5.5}Ta_{0.5}O₁₄, ...).

Dans les années 1980, l'apparition de composants micro-électro-mécaniques (MEMS) a ouvert la voie vers la miniaturisation de capteurs, d'actionneurs ou de résonateurs, ce qui a bénéficié au développement de la téléphonie mobile, et des capteurs pour l'automobile. La réalisation de MEMS piézoélectriques a été rendue possible par le développement de couches minces piézoélectriques. Ces couches se caractérisent par une épaisseur de l'ordre du micromètre, voire moins. De manière courante, seuls quelques matériaux, souvent polycristallins, sont disponibles sous forme de couches minces : l'oxyde de zinc (ZnO), le nitrure d'aluminium (AIN) ou à nouveau le PZT. A l'heure actuelle, ces deux derniers matériaux sont utilisés dans l'industrie avec succès.

Les couches de nitrure d'aluminium sont actuellement principalement utilisées pour la réalisation de filtres à ondes acoustiques de volume. Ces filtres sont des circuits utilisant plusieurs résonateurs à ondes acoustiques de volume, qui reposent sur la résonance sur un mode d'épaisseur de la couche piézoélectrique, généralement en AIN. Pendant longtemps, ce matériau a en effet disposé de coefficients piézoélectriques relativement en accord avec ce que nécessitaient les applications de la téléphonie mobile. En effet, il existe une relation de proportionnalité entre le coefficient de couplage électromécanique d'une onde se propageant dans un matériau piézoélectrique (ce coefficient de couplage étant défini comme étant le rapport entre la quantité d'énergie convertie du domaine électrique vers le domaine mécanique, ou vice-versa, et la quantité d'énergie stockée sous forme électrique et mécanique dans la structure) et la largeur de bande relative qu'il est possible de synthétiser à partir d'un circuit de filtre. Avec la maturation de la technologie des filtres à ondes élastiques, et l'apparition de nouveaux standards de télécommunications (par exemple, la 5^{e} génération de téléphonie mobile, appelée aussi 5G), on assiste à l'ouverture de nouvelles bandes de fréquences à des fréquences élevées (au-delà de 3 GHz), à l'ouverture de bandes relativement larges, ou à la diminution de l'espacement entre bandes de fréquences utilisées. De plus, la recherche est actuellement active dans le développement de résonateurs ou de circuits de filtres agiles en fréquence. Tous ces cas de figure nécessitent des résonateurs possédant des coefficients de couplage électromécaniques plus élevés que ce que peut fournir le nitrure d'aluminium.

On a donc assisté ces dernières années au développement d'alliages dérivés de l'AIN, incorporant par exemple du Scandium ou du Chrome (AIScN ou AlCrN). La modification de la composition du matériau piézoélectrique permet des gains substantiels en coefficients de couplage piézoélectrique (passage d'environ 6 % à plus de 10 %), sans modification majeure des procédés de réalisation. Les besoins sont néanmoins tels que ces améliorations ne sont pas entièrement suffisantes. Il a donc été proposé de baser les résonateurs à ondes acoustiques de volume sur des matériaux tels que le niobate de lithium ou le tantalate de lithium. Le niobate de lithium permet en théorie d'exciter des ondes de cisaillement pouvant présenter des coefficients de couplage électromécaniques pouvant atteindre 45 %. Ceci n'est toutefois vrai que pour certaines orientations cristallines bien spécifiques.

En pratique, les travaux les plus avancés sur ce matériau sont ceux de Kadota *et al.* (M. Kadota, Y. Suzuki et Y. Ito, IEEE International Ultrasonics Symposium 2010 ou M. Kadota, T. Ogami, K. Yamamoto, H. Tochishita, Y. Negoro, IEEE Transactions on Ultrasonics, Ferroelectrics and Frequency Control vol 57, n°11, p. 2564 (2010*)),* qui ont réalisé des résonateurs à ondes de Lamb et à ondes de volume à partir d'empilement substrat / couche sacrifiée / électrode / film de niobate de lithium épitaxié / électrode. Ces couches de niobate de lithium présentent une orientation dite axe c, correspondant à l'axe cristallin (000.6) ou à la direction Z selon la norme ANSI/IEEE 176-1987. Cette orientation ne présente que des coefficients de couplage électromécaniques quasiment identiques à ceux du nitrure d'aluminium, présentant relativement peu d'intérêt au regard de la difficulté à déposer ce matériau. En effet, la croissance de ce matériau nécessite des températures élevées (de l'ordre de 500 à 700°C) et des temps relativement longs (de l'ordre de quelques heures), au cours desquels les risques de diffusion de lithium dans les autres couches en présence sont forts, rendant délicat la maîtrise de la composition chimique et des interfaces.

Pour contourner ces problématiques, plusieurs réalisations se sont basées sur des techniques de report de films minces monocristallins. Des couches minces sont dans ce cas prélevées d'un substrat massif monocristallin pour être incorporées dans l'empilement de composants acoustiques. Trois techniques existent :
- le collage / amincissement : le principe consiste à venir coller un substrat piézoélectrique sur le substrat hôte, puis à venir amincir le matériau piézoélectrique par rodage mécanique, suivi d'un polissage. Dans certains cas, on peut utiliser également des étapes de gravure pour consommer plus rapidement le matériau ;
- le collage / fracturation : le principe consiste à implanter des ions légers à une profondeur donnée dans le substrat piézoélectrique, et à relativement forte dose. On vient ensuite coller ce substrat sur le substrat hôte. Un traitement thermique permet ensuite de fragiliser l'interface où sont piégés les ions implantés, ce qui provoque la fracture du matériau. Il ne subsiste alors qu'une couche mince piézoélectrique collée au substrat hôte d'un côté, et le substrat piézoélectrique donneur aminci de l'autre ;
- le collage / dissolution : cette variante de la méthode précédente consiste à utiliser le fait que le matériau piézoélectrique est endommagé par la présence localisée à une certaine profondeur d'une grande quantité d'ions implantés. Il est donc à cet endroit beaucoup plus facilement gravé par une dissolution chimique que les régions environnantes. Cet effet peut alors être utilisé pour détacher la couche mince collée au substrat hôte du reste du substrat piézoélectrique.

Ces trois techniques présentent l'avantage de fournir des couches piézoélectriques monocristallines, d'excellente qualité et qui plus est de virtuellement n'importe quelle orientation cristalline (pourvu que des substrats monocristallins présentant cette orientation soient disponibles). Elles sont donc très versatiles. Néanmoins, nécessitant des étapes de collage et des traitements lourds pour parvenir à détacher la couche que l'on désire conserver, leur mise en place est relativement délicate. Ceci nécessite en particulier des recuits de consolidation de l'interface de collage, le cas échéant de fracture et enfin de guérison des endommagements du matériau provenant de la fracturation, de l'implantation, voire de l'abrasion mécanique du cristal. Ceci peut poser des problèmes de compatibilité avec des structures en présence sur le substrat hôte, qui risquent de se dégrader en raison du budget thermique appliqué durant le recuit de guérison. Un autre problème peut également provenir des différences de coefficients de dilatation entre le substrat donneur (piézoélectrique) et le substrat receveur (idéalement en silicium), qui, lors de tentatives d'applications du procédé de collage/fracturation peut provoquer des casses de plaque lors du recuit de fracturation, lorsque les deux substrats épais subissent un fort différentiel de dilatation thermique. Enfin, une dernière limitation de ces techniques réside dans la difficulté à envisager une transposition sur des substrats de grandes dimensions (diamètres de 200 ou 300 mm) : en effet, les substrats piézoélectriques monocristallins sont au mieux disponibles à l'heure actuelle en diamètre de 150 mm, et les problématiques de différentiels de dilatation se font plus prégnantes à mesures que les dimensions latérales des substrats augmentent.

Recourir à des étapes de dépôt du matériau piézoélectrique serait donc plus simple. Néanmoins, l'obtention d'une orientation cristalline autre que l'orientation naturelle de croissance nécessite une croissance épitaxiale sur des surfaces ad hoc soit généralement des dispositions atomiques en surface compatible avec les plans cristallins du matériau piézoélectrique que l'on désire faire croître. Les substrats doivent donc être soumis à des traitements chimiques et thermiques spécifiques révélant des marches atomiques. Ces conditions sont extrêmement restrictives et nécessitent généralement la présence de couches elles-mêmes monocristallines ou épitaxiées et présentant des états de surface extrêmement contrôlés. Ceci n'est typiquement pas le cas des empilements obtenus après une succession d'étapes de fabrication, et n'est surtout pas le cas d'électrodes métalliques sur lesquelles on désire généralement déposer le matériau piézoélectrique, a fortiori lorsque ces électrodes présentent une géométrie donnée et ne s'étendent pas sur l'ensemble de la surface du substrat. De plus, la croissance sur des épaisseurs importantes (plusieurs centaines de nm à quelques µm en fonction des matériaux) entraîne un relâchement des contraintes dues au désaccord de maille cristalline entre le substrat et la couche épitaxiée, qui conduit à la formation de dislocations qui peuvent nuire à l'intégrité du film si elles sont trop nombreuses. Pour cette raison, les films épitaxiés sont généralement limités en épaisseur. Par ailleurs, comme cela a été mentionné, ces structures possèdent une forte probabilité d'être dégradées en raison du budget thermique nécessaire au dépôt, et de la réactivité chimique d'espèces présentes.

Le document EP2464006 divulgue un procédé dans lequel il est prévu une étape d'implantation de manière à définir une couche de matériau d'intérêt qui pourra être dissociée du substrat depuis lequel elle est issue. Le document Reinhardt Alexandre et Al : « Acoustic filters based on thin single crystal LiNbO3 films : Status and prospects » 2014 IEEE International Ultrasonics Symposium, IEEE, 3 septembre 2014, pages 773-781, XP033266727, DOI :10.1109/ULTSYM.2014.0191, divulgue une étape d'implantation pour définir une couche mince. Le document US2013/0249648 décrit une étape d'implantation ionique d'atomes afin de créer une zone de défauts à la profondeur désirée. Le document WO2011/042388 décrit la réalisation d'une opération d'implantation ionique pour créer une zone fragile enterrée permettant de définir la couche mince piézoélectrique. Le document WO2019/129979 décrit une zone fracturée. Les documents EP3591724 et WO2020006578 divulguent un procédé de fabrication d'un système micro-électro-mécanique.

La demande de brevet US 2017 0077386 A1 décrit une technique permettant de contourner ce problème : le matériau est épitaxié sur un substrat de croissance, incluant éventuellement des sous-couches d'accommodation des relations d'épitaxie entre le substrat et la couche piézoélectrique. On vient ensuite former la partie supérieure de l'empilement du résonateur. On vient ensuite procéder à la gravure localisée d'ouvertures à travers le substrat, ce qui permet de libérer le résonateur et de le découpler mécaniquement du substrat. Au fond de ces ouvertures, les électrodes inférieures sont alors déposées et structurées. Cette technique présente toutefois plusieurs inconvénients :
- les substrats sont grandement fragilisés par la gravure des ouvertures, ce qui limite la densité de motifs qu'il est possible de réaliser. Ceci nuit donc à la compacité des filtres et/ou au rendement de fabrication ;
- certains substrats de croissance, par exemple le saphir, sont notoirement difficile à graver sur de fortes épaisseurs en raison de leur inertie chimique et de leur dureté. Il en résulte que l'étape de gravure se révèle coûteuse, à supposer même qu'elle soit possible sur de grandes profondeurs ;
- la définition des motifs d'électrodes inférieures au fond des cavités (profondes de plusieurs centaines de µm) est délicate, puisque les équipements de photolithographie devront être utilisés hors de leur profondeur de champ. Les motifs ne pourront donc pas être précisément définis.

C'est pourquoi dans ce contexte, le Demandeur propose dans la présente invention, un procédé de réalisation de composants micro-électro-mécaniques utilisant une couche mince piézoélectrique et particulièrement bien adapté dans le cas de couche mince piézoélectrique épitaxiée et prise en sandwich entre deux électrodes, permettant de ne pas dégrader l'électrode inférieure le cas échéant, ni subir les défauts des techniques présentées dans l'état de l'art ci-dessus.

Plus précisément la présente invention a pour objet un procédé de fabrication d'un système micro-électro-mécanique selon la revendication indépendante de procédé 1.

Selon des variantes de l'invention, le dépôt dudit matériau piézoélectrique ou dudit matériau ferroélectrique est réalisé par croissance épitaxiale.

Selon des variantes de l'invention, le système micro-électro-mécanique comprend au moins un résonateur à ondes élastiques de volume ou au moins un résonateur à ondes élastiques de surface ou au moins un résonateur à ondes de Lamb.

Selon des variantes de l'invention, le collage comprend une étape de recuit thermique.

Selon des variantes de l'invention, l'opération de retrait du substrat temporaire comprend :
- une étape d'amincissement dudit substrat temporaire ;
- une opération de gravure chimique dudit substrat temporaire aminci.

Selon des variantes de l'invention, l'opération de retrait dudit substrat temporaire comprend :
- une étape de diffusion d'éléments provoquant des précipitations ou des réactions chimiques au niveau du matériau constituant ledit substrat temporaire ou
- une étape d'implantation d'ions dans ledit substrat temporaire.

Selon des variantes de l'invention, le procédé comprend le dépôt d'une couche tampon à la surface dudit substrat temporaire, préalable au dépôt dudit matériau piézoélectrique ou dudit matériau ferroélectrique.

Selon des variantes de l'invention, le procédé comprend la réalisation de couches structurées en métal pouvant être du Molybdène insérées dans du diélectrique pouvant être du SiO₂.

Selon des variantes de l'invention, le procédé comporte préalablement audit collage desdits deux ensembles :
- la réalisation d'électrodes à la surface de ladite couche de matériau piézoélectrique ou de matériau ferroélectrique ;
- la réalisation d'une structure d'isolation acoustique dans ledit second ensemble.

Selon des variantes de l'invention, le matériau piézoélectrique est LiNbO₃ ou LiTaO₃, ou leurs solutions solides ou KNbO₃ ou AIN, GaN.

Selon des variantes de l'invention, le matériau ferroélectrique est : LiNbO₃ ou LiTaO₃ ou PZT

Selon des variantes, le substrat temporaire est en matériau non silicium, tels que par exemple des matériaux de MgO, de SrTiO₃, de LaAlO₃, de LSAT ((LaAlO₃)_{0.3}(Sr₂TaAlO₆)_{0.7}), de DyScO₃, de Saphir (Al₂O₃) ou de niobate de lithium (LiNbO₃), tantalate de lithium, le matériau piézoélectrique pouvant avantageusement être du PZT.

Selon des variantes de l'invention, les couches de collage sont en oxyde ou en polymère.

L'invention a aussi pour objet un système micro-électro-mécanique obtenu par le procédé de l'invention.

L'invention sera mieux comprise et d'autres avantages apparaîtront à la lecture de la description qui va suivre donnée à titre non limitatif et grâce aux figures annexées parmi lesquelles :
[Fig.1a] illustre la première étape d'un premier exemple de procédé de réalisation d'un système comprenant un résonateur à ondes de volume selon l'invention comprenant une structure sacrifiée libérée ;
[Fig.1b] illustre la deuxième étape d'un premier exemple de procédé de réalisation d'un système comprenant un résonateur à ondes de volume selon l'invention comprenant une structure sacrifiée libérée ;
[Fig.1c] illustre la troisième étape d'un premier exemple de procédé de réalisation d'un système comprenant un résonateur à ondes de volume selon l'invention comprenant une structure sacrifiée libérée ;
[Fig.1d] illustre la quatrième étape d'un premier exemple de procédé de réalisation d'un système comprenant un résonateur à ondes de volume selon l'invention comprenant une structure sacrifiée libérée ;
[Fig.1e] illustre la cinquième étape d'un premier exemple de procédé de réalisation d'un système comprenant un résonateur à ondes de volume selon l'invention comprenant une structure sacrifiée libérée ;
[Fig.1f] illustre la sixième étape d'un premier exemple de procédé de réalisation d'un système comprenant un résonateur à ondes de volume selon l'invention comprenant une structure sacrifiée libérée ;
[Fig.1g] illustre la septième étape d'un premier exemple de procédé de réalisation d'un système comprenant un résonateur à ondes de volume selon l'invention comprenant une structure sacrifiée libérée ;
[Fig.1h] illustre la huitième étape d'un premier exemple de procédé de réalisation d'un système comprenant un résonateur à ondes de volume selon l'invention comprenant une structure sacrifiée libérée ;
[Fig.1i] illustre la neuvième étape d'un premier exemple de procédé de réalisation d'un système comprenant un résonateur à ondes de volume selon l'invention comprenant une structure sacrifiée libérée ;
[Fig.1j] illustre la dixième étape d'un premier exemple de procédé de réalisation d'un système comprenant un résonateur à ondes de volume selon l'invention comprenant une structure sacrifiée libérée ;
[Fig.1k] illustre la onzième étape d'un premier exemple de procédé de réalisation d'un système comprenant un résonateur à ondes de volume selon l'invention comprenant une structure sacrifiée libérée ;
[Fig.1l] illustre la douzième étape d'un premier exemple de procédé de réalisation d'un système comprenant un résonateur à ondes de volume selon l'invention comprenant une structure sacrifiée libérée ;
[Fig.1m] illustre la treizième étape d'un premier exemple de procédé de réalisation d'un système comprenant un résonateur à ondes de volume selon l'invention comprenant une structure sacrifiée libérée ;
[Fig.1n] illustre la quatorzième étape d'un premier exemple de procédé de réalisation d'un système comprenant un résonateur à ondes de volume selon l'invention comprenant une structure sacrifiée libérée ;
[Fig.1o] illustre la quinzième étape d'un premier exemple de procédé de réalisation d'un système comprenant un résonateur à ondes de volume selon l'invention comprenant une structure sacrifiée libérée ;
[Fig.2a] illustre la première étape d'un deuxième exemple de procédé de réalisation d'un système comprenant un résonateur à ondes de volume selon l'invention comprenant une structure de miroir de Bragg ;
[Fig.2b] illustre la deuxième étape d'un deuxième exemple de procédé de réalisation d'un système comprenant un résonateur à ondes de volume selon l'invention comprenant une structure de miroir de Bragg ;
[Fig.2c] illustre la troisième étape d'un deuxième exemple de procédé de réalisation d'un système comprenant un résonateur à ondes de volume selon l'invention comprenant une structure de miroir de Bragg ;
[Fig.2d] illustre la quatrième étape d'un deuxième exemple de procédé de réalisation d'un système comprenant un résonateur à ondes de volume selon l'invention comprenant une structure de miroir de Bragg ;
[Fig.2e] illustre la cinquième étape d'un deuxième exemple de procédé de réalisation d'un système comprenant un résonateur à ondes de volume selon l'invention comprenant une structure de miroir de Bragg ;
[Fig.2f] illustre la sixième étape d'un deuxième exemple de procédé de réalisation d'un système comprenant un résonateur à ondes de volume selon l'invention comprenant une structure de miroir de Bragg ;
[Fig.3a] illustre la première étape d'un exemple de procédé de réalisation d'un système comprenant un résonateur à ondes de plaque selon l'invention ;
[Fig.3b] illustre la deuxième étape d'un exemple de procédé de réalisation d'un système comprenant un résonateur à ondes de plaque selon l'invention ;
[Fig.3c] illustre la troisième étape d'un exemple de procédé de réalisation d'un système comprenant un résonateur à ondes de plaque selon l'invention ;
[Fig.3d] illustre la quatrième étape d'un exemple de procédé de réalisation d'un système comprenant un résonateur à ondes de plaque selon l'invention ;
[Fig.3e] illustre la cinquième étape d'un exemple de procédé de réalisation d'un système comprenant un résonateur à ondes de plaque selon l'invention ;
[Fig.4a] illustre la première étape d'un exemple de procédé de réalisation d'un transformateur comprenant deux résonateurs à ondes de Lamb selon l'invention ;
[Fig.4b] illustre la deuxième étape d'un exemple de procédé de réalisation d'un transformateur comprenant deux résonateurs à ondes de Lamb selon l'invention ;
[Fig.4c] illustre la troisième étape d'un exemple de procédé de réalisation d'un transformateur comprenant deux résonateurs à ondes de Lamb selon l'invention ;
[Fig.4d] illustre la quatrième étape d'un exemple de procédé de réalisation d'un transformateur comprenant deux résonateurs à ondes de Lamb selon l'invention ;
[Fig.4e] illustre la cinquième étape d'un exemple de procédé de réalisation d'un transformateur comprenant deux résonateurs à ondes de Lamb selon l'invention ;
[Fig.4f] illustre la sixième étape d'un exemple de procédé de réalisation d'un transformateur comprenant deux résonateurs à ondes de Lamb selon l'invention ;
[Fig.4g] illustre la septième étape d'un exemple de procédé de réalisation d'un transformateur comprenant deux résonateurs à ondes de Lamb selon l'invention ;
[Fig.4h] illustre la huitième étape d'un exemple de procédé de réalisation d'un transformateur comprenant deux résonateurs à ondes de Lamb selon l'invention ;
[Fig.4i] illustre la neuvième étape d'un exemple de procédé de réalisation d'un transformateur comprenant deux résonateurs à ondes de Lamb selon l'invention ;
[Fig.4j] illustre la dixième étape d'un exemple de procédé de réalisation d'un transformateur comprenant deux résonateurs à ondes de Lamb selon l'invention ;
[Fig.4k] illustre la onzième étape d'un exemple de procédé de réalisation d'un transformateur comprenant deux résonateurs à ondes de Lamb selon l'invention ;
[Fig.4l] illustre la douzième étape d'un exemple de procédé de réalisation d'un transformateur comprenant deux résonateurs à ondes de Lamb selon l'invention ;
[Fig.4m] illustre la treizième étape d'un exemple de procédé de réalisation d'un transformateur comprenant deux résonateurs à ondes de Lamb selon l'invention ;
[Fig.4n] illustre la quatorzième étape d'un exemple de procédé de réalisation d'un transformateur comprenant deux résonateurs à ondes de Lamb selon l'invention.

Le procédé de la présente invention comporte ainsi les principales étapes suivantes déclinées selon certaines variantes et certaines options :
- la préparation d'un substrat temporaire pouvant correspondre à un substrat de croissance adéquat. Ceci peut nécessiter des traitements de surface du substrat et/ou le dépôt de couches d'adaptation des relations d'épitaxie entre la couche à déposer et le substrat de croissance ;
- le dépôt de la couche piézoélectrique ou ferroélectrique par une technique adéquate pour parvenir à faire croître un matériau monocristallin, ou à défaut texturé ;
- la réalisation de la partie inférieure du composant par-dessus la couche déposée, ou sur un autre substrat (le futur substrat hôte). Cette partie inférieure peut comporter des électrodes ou autres, ou *a minima* une structure d'isolation acoustique du résonateur à ondes acoustiques qui sera formé : caisson de libération qui permettra d'insérer un miroir de Bragg ;
- le collage du substrat de croissance comportant la couche épitaxiée le cas échéant et une partie des structures de la partie inférieure du composant sur le substrat hôte possédant éventuellement le complémentaire de cette partie inférieure (pouvant être une structure de couche sacrifiée, au moins une électrode...) ;
- le détachage du substrat temporaire pouvant être un substrat de croissance, par des moyens connus de l'homme de l'art (gravure chimique ou physique du substrat ou d'une des couches incorporées au substrat de croissance) ;
- la finalisation de la fabrication du composant en réalisant la partie supérieure du composant.

Le Demandeur décrit ci-après plusieurs exemples de procédés dont les étapes sont illustrées par des figures sur lesquelles les mêmes références sont employées et qui correspondent respectivement aux éléments suivants :
**100** : un substrat temporaire
**200** : une couche tampon
**300** : une couche de matériau piézoélectrique ou de matériau ferroélectrique
**400** : au moins une électrode inférieure
**500a, 500b, 500c -> 500** : du matériau diélectrique, notamment destiné au collage
**600** : une structure de couche sacrifiée
**MR :** une structure de miroir de Bragg
**700 :** un substrat hôte
**800 :** au moins une électrode supérieure
**900 :** une couche diélectrique supérieure
**1000** : des plots de contact

Les exemples ci-après sont décrits dans le cadre de matériaux piézoélectriques, mais peuvent tout aussi bien être appliqués dans le cadre de matériaux ferroélectriques.

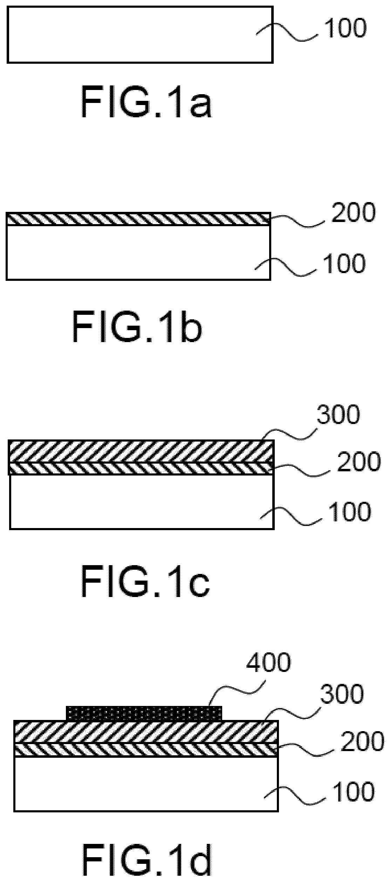

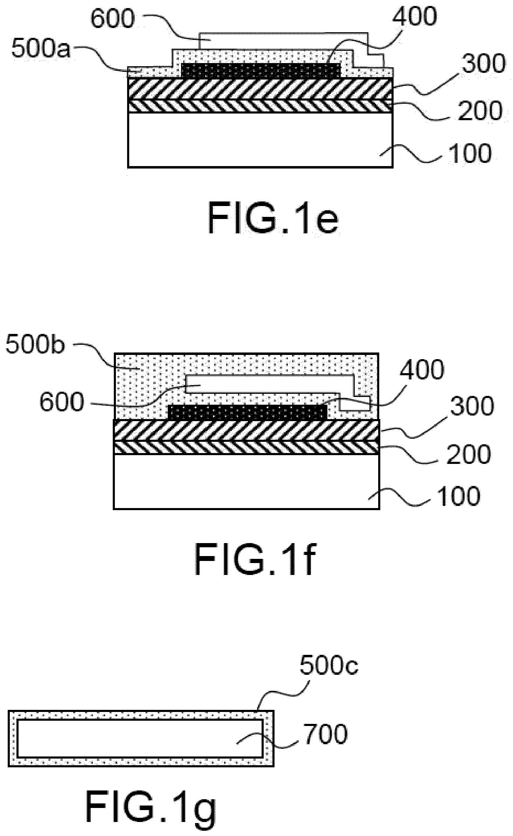

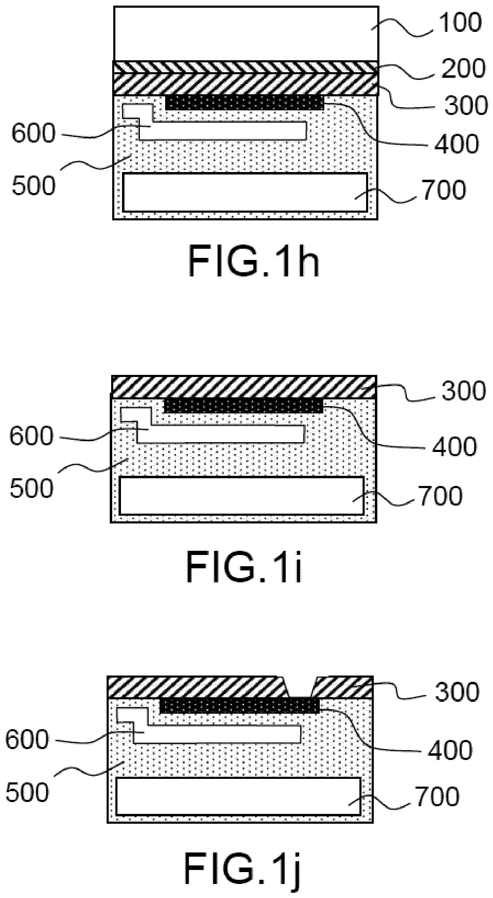

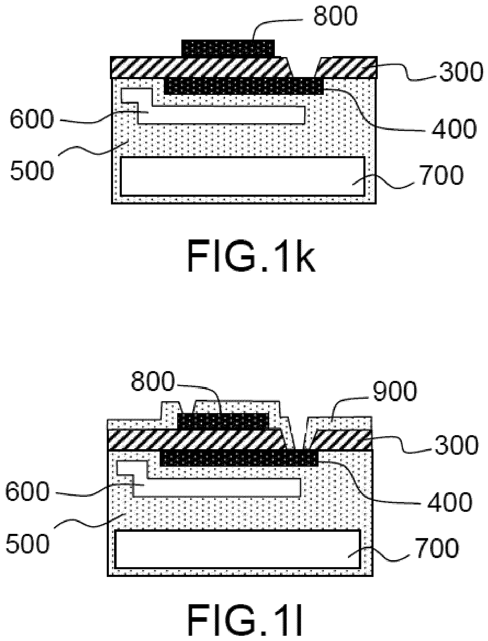

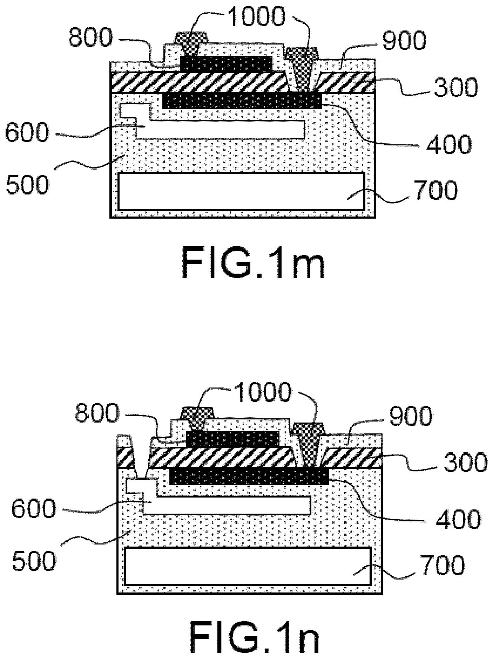

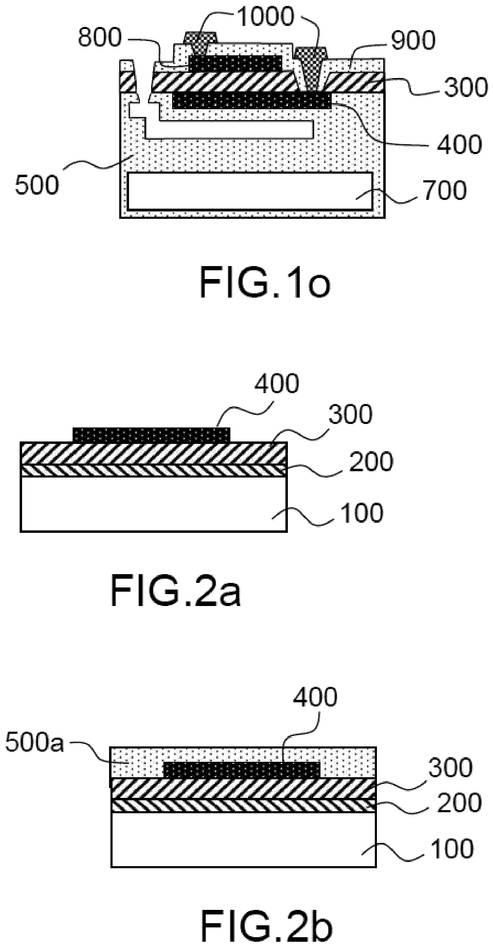

Exemple de procédé de fabrication d'un résonateur à ondes de volume comprenant une structure sacrifiée libérée :
Etape 1.1 :
   On réalise la préparation d'un substrat de silicium correspondant au substrat temporaire **100** par un recuit haute température (> 1000°C) afin d'obtenir une surface lisse au niveau atomique, comme illustré en figure 1a.
Etape 1.2 :
   On procède au dépôt d'une couche tampon **200,** par exemple de ZnO par épitaxie par jet moléculaire (MBE, pour *Molecular Beam Epitaxy*), d'une épaisseur par exemple de 20 nm, comme illustré en figure 1b.
Etape 1.3 :
   On procède au dépôt d'une couche de LiNbO₃ par exemple par PI-MOCVD (*Pulsed Injection Metal-Organic Chemical Vapor Déposition*), par exemple de 250 nm d'épaisseur. L'accord de maille cristalline entre le Si/ZnO/LiNbO₃ conduit par exemple à la croissance d'une couche de niobate de lithium selon l'axe c **300,** comme illustré en figure 1c.
Etape 1.4 :
   On procède au dépôt d'une électrode inférieure **400,** par exemple en molybdène de 100 nm d'épaisseur, par pulvérisation, puis structuration par photolithographie, gravure ionique réactive et retrait de résine, comme illustré en figure 1d.
Etape 1.5 :
   On procède au dépôt d'une couche de protection de diélectrique en SiO₂ **500a** par exemple en PECVD (*Plasma Enhanced Chemical Vapor Deposition*), par exemple de 100 nm d'épaisseur, puis au dépôt d'une couche sacrifiée en silicium amorphe, par exemple de 1 µm, par pulvérisation. On procède à la structuration de celle-ci par photolithographie, gravure ionique réactive et retrait de résine, pour obtenir une structure de couche sacrifiée **600** comme illustré en figure 1e.
Etape 1.6 :
   On procède au dépôt de diélectrique SiO₂ **500b** par exemple, de 2 µm d'épaisseur par exemple, par pulvérisation réactive de Si par un plasma Ar/O₂ et polissage mécano-chimique (CMP, pour *Chemical Mechanical Polishing*), comme illustré en figure 1f.
Etape 1.7 :
   Par ailleurs, on prépare un substrat recouvert d'une couche **500c** par oxydation thermique d'un substrat de silicium hôte **700,** par exemple sur une épaisseur de 500 nm, comme illustré en figure 1g.
Etape 1.8 :
   On procède alors à l'activation des surfaces et au collage direct entre substrat hôte **700** et substrat temporaire **100** correspondant à un substrat de croissance puis à une opération de recuit de consolidation du collage via le diélectrique **500** comme illustré en figure 1h.
Etape 1.9 :
   On procède à une opération de détachage du substrat temporaire de croissance **100.** On procède à un amincissement par rodage mécanique visant à ne laisser qu'une dizaine de microns d'épaisseur, puis à une gravure chimique du substrat temporaire de croissance dans une solution de TMAH (*Tetramethylammonium Hidroxide*) et à la gravure chimique de la couche tampon **200** de ZnO par exemple par HCl, comme illustré en figure 1i.
Etape 1.10 :
   On procède à la gravure destinée à des contacts électriques vers l'électrode inférieure, par photolithographie, gravure par faisceau d'ion (IBE, pour *Ion Beam Etching*) de la couche piézoélectrique **300,** et retrait de résine, comme illustré en figure 1j.
Etape 1.11 :
   On procède au dépôt et à la structuration d'une électrode supérieure **800** (toujours en Mo, par exemple de 100 nm d'épaisseur), comme illustré en figure 1k.
Etape 1.12 :
   On procède alors à l'encapsulation de l'électrode supérieure par une couche de SiO₂ **900** déposée par exemple par PECVD, par exemple à nouveau de 100 nm d'épaisseur. Puis on procède à l'ouverture de contacts électriques dans le film par photolithographie, gravure ionique réactive et retrait de résine, comme illustré en figure 1l.
Etape 1.13 :
   On procède au dépôt de contacts électriques **1000,** par exemple en aluminium par pulvérisation, sur une épaisseur de 1µm, photolithographie, gravure chimique et retrait de résine comme illustré en figure 1m.
Etape 1.14 :
   On procède à la gravure d'ouvertures de libération par gravure par faisceau d'ions d'un empilement SiO₂ / LiNbO₃ / SiO₂ comme illustré en figure 1n.
Etape 1.15 :
   On procède à la libération du résonateur (couche de matériau piézoélectrique entre électrodes) par gravure de la structure de couche sacrifiée en silicium amorphe **600** par XeF₂ gazeux comme illustré en figure 1o.
Etape 1.16 :
   On applique enfin une tension électrique aux bornes du composant et l'on chauffe de celui-ci afin d'orienter les domaines ferroélectriques dans la couche de niobate de lithium dans une direction préférentielle.

### Exemple de procédé de réalisation d'un résonateur à ondes acoustiques de volume en niobate de lithium épitaxié, sur miroir de Bragg

Une variante du précédent procédé de réalisation consiste à remplacer le confinement acoustique apporté par la cavité d'air localisée sous le résonateur par un confinement acoustique apporté par un miroir de Bragg constitué d'un empilement de couches alternativement à basse et haute impédances acoustiques. Parmi les matériaux possédant une impédance acoustique élevée, on considère habituellement des couches de tungstène (W), molybdène (Mo), de nitrure de silicium (SiN) ou de nitrure d'aluminium (AIN). Pour les matériaux possédant une faible impédance acoustique, la littérature mentionne surtout l'utilisation d'oxyde de Silicium (SiO₂), mais cite également l'oxycarbure de silicium (SiOC). Ces listes ne sont pas limitatives.

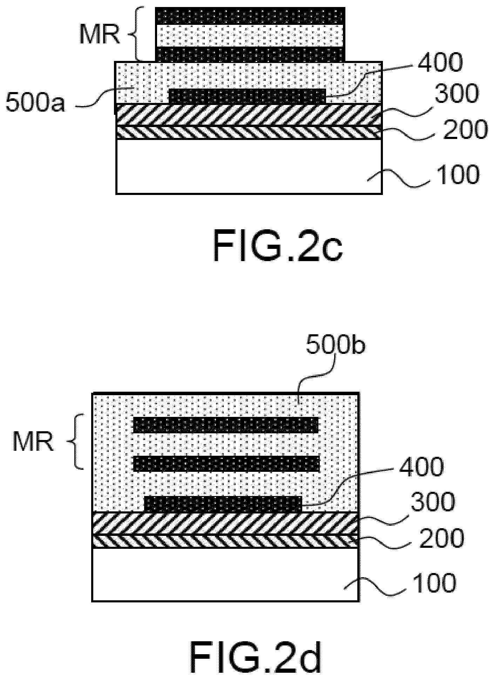

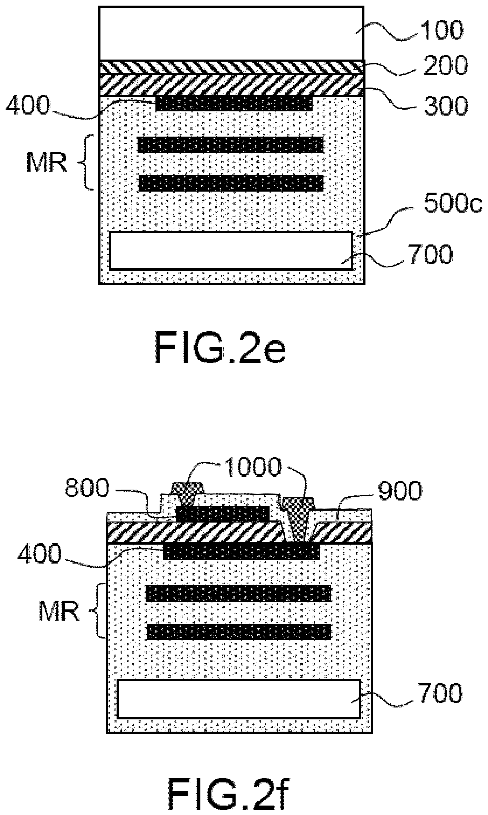

Un procédé adapté à la réalisation de résonateurs SMR (pour *Solidly Mounted Resonator*), nom donné aux résonateurs à ondes de volume sur miroir de Bragg, est décrit ci-après :
Etape 2.1 :
   On procède aux étapes 1.1 à 1.4. du premier procédé jusqu'à la réalisation des électrodes inférieures comme décrit en figure 2a, de manière à définir sur un substrat temporaire **100,** une couche tampon **200,** une couche de matériau piézoélectrique **300** et une électrode inférieure **400.**
Etape 2.2. :
   On procède au dépôt d'une couche de protection en SiO₂ **500a** par exemple en PECVD (*Plasma Enhanced Chemical Vapor Déposition*), par exemple de 600 nm d'épaisseur et planarisation de la topographie apportée par l'électrode inférieure. Le restant de la couche de SiO₂ fera office de couche supérieure du miroir de Bragg, comme illustré en figure 2b.
Etape 2.3 :
   On procède au dépôt des couches suivantes constitutives du miroir de Bragg **MR,** ici par exemple un miroir SiO₂/Mo (250 nm)/SiO₂ (250 nm)/Mo (400 nm). Puis on procède à des opérations de photolithographie et gravure ionique réactive du tricouche Mo/SiO₂/Mo comme illustré en figure 2c.
Etape 2.4 :
   On procède au dépôt d'une couche de 2 µm de SiO₂ **500b,** par exemple par PECVD, et planarisation de la topographie apportée par le miroir de Bragg **MR** comme illustré en figure 2d.
Etape 2.5 :
   On procède à l'activation des surfaces et collage direct entre substrat hôte (un substrat de silicium oxydé) **700 + 500c** et substrat temporaire de croissance **100** avec miroir de Bragg **MR**. On procède à une opération de recuit de consolidation du collage comme illustré en figure 2e.
Etape 2.6 :
   On procède au détachage du substrat temporaire de croissance **100,** comme dans le mode de réalisation précédent, puis on poursuit les étapes de manière similaire à celles du procédé de réalisation jusqu'à la finalisation des contacts électriques. En raison de la présence d'un miroir de Bragg **MR** en remplacement des caissons de couche sacrifiée, l'étape de libération n'est plus nécessaire, comme illustré en figure 2f.

### Exemple de procédé de réalisation d'un résonateur à ondes de Lamb en niobate de lithium épitaxié

Les procédés décrits précédemment ne s'appliquent pas uniquement à des résonateurs à ondes acoustiques de volume, mais peuvent également être utilisés pour la réalisation de résonateurs à ondes acoustiques de plaque, aussi dénotés résonateurs à ondes de Lamb. Ces résonateurs se distinguent par une excitation des ondes acoustiques non plus par deux électrodes pleines prenant la couche piézoélectrique en sandwich, mais par deux électrodes en forme de peignes interdigités positionnées sur l'une des faces (inférieure ou supérieure) de la couche piézoélectrique. L'autre face peut être en contact avec une électrode couvrant la surface du composant (afin d'exciter des ondes de plaque à partir du champ électrique vertical ainsi formé), ou au contraire ne pas comporter d'électrode, afin d'exciter des ondes à partir du champ électrique horizontal formé entre les électrodes du peigne interdigité. Plus généralement, ce procédé peut s'appliquer à toute une famille de micro-résonateurs acoustiques bénéficiant d'une couche piézoélectrique épitaxiée.

Par ailleurs, des variantes de réalisation peuvent être introduites dans les procédés précédents. En particulier, d'autres techniques de détachage du substrat de croissance sont envisageables.

En effet, l'étape 1.9) du premier exemple de procédé repose sur une gravure chimique du substrat de croissance. Dans le cas où ce dernier n'est pas en silicium et est donc difficile à dissoudre chimiquement, ou pour des gains de temps, il peut être avantageux de procéder à un amincissement mécanique (*grinding* en anglais) au moyen de techniques de rodage et de polissage mécano-chimique. Un inconvénient persiste tout de même : le procédé entraîne une consommation du substrat de croissance, et donc sa perte, ce qui entraîne un coût notable. Afin de contourner cette problématique, il peut être intéressant de provoquer une fracture mécanique du substrat de croissance, qui pourra ensuite être réutilisé moyennant des étapes de reconditionnement. Cette fracture peut être obtenue de différentes manières. On peut citer :
- la génération d'une interface fragile lors de la croissance de la couche piézoélectrique. Ceci peut se produire majoritairement lorsque l'on assiste à la diffusion d'un élément provoquant des précipitations ou des réactions chimiques entraînant l'augmentation de volume d'un des matériaux encapsulés en présence, et donc des décollements spontanés lors d'une sollicitation mécanique ;
- une autre technique consiste à former une interface fragile après la croissance de la couche piézoélectrique. Cette interface peut être formée par implantation d'ions dans le substrat de croissance, puis recuit thermique pour provoquer une fracture du matériau, selon un procédé similaire au procédé Smart Cut^{™}. Ceci est possible lorsque la couche épitaxiée et l'ensemble des sous-couches d'accommodation des paramètres de maille présentent une épaisseur relativement faible, de façon à pouvoir être traversée par le flux d'ions durant l'implantation.

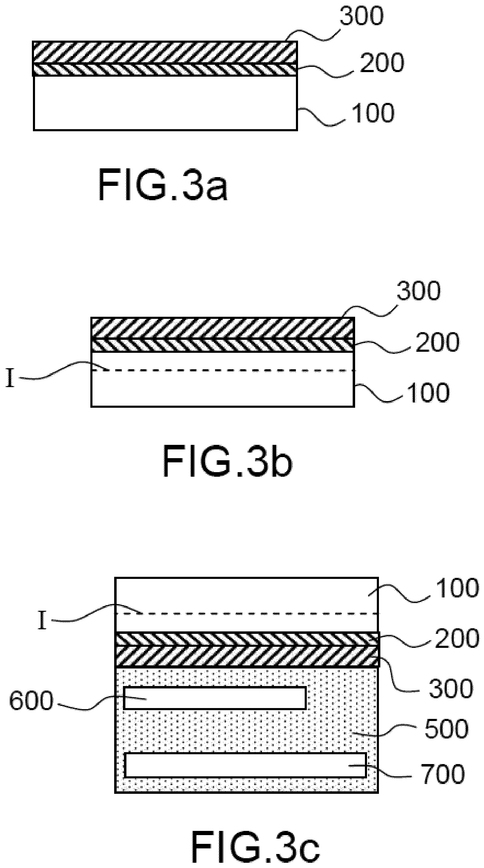

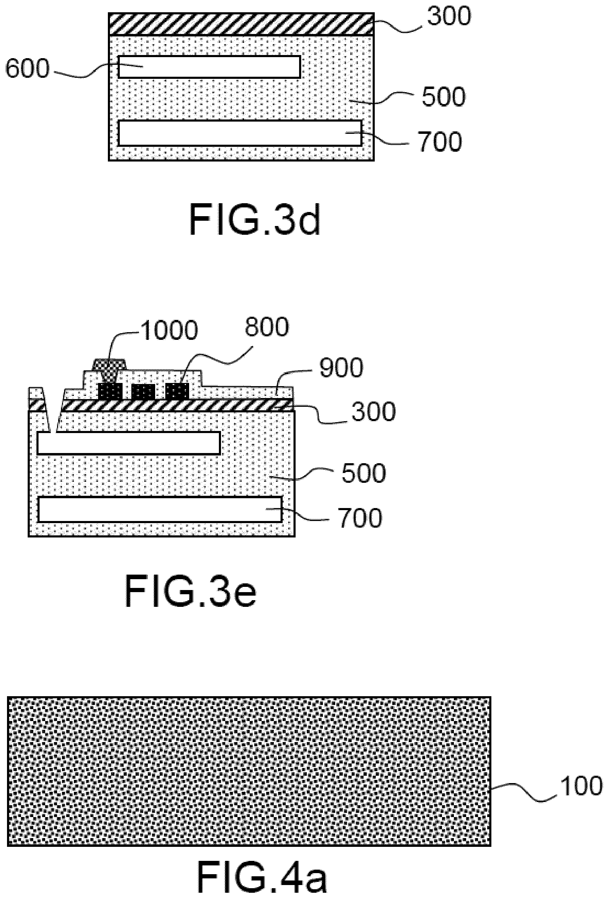

Ainsi, une variante de procédé de réalisation destinée par exemple à réaliser un résonateur à ondes acoustiques de plaque est décrite ci-après :
Etape 3.1 :
   On procède à la croissance épitaxiale d'une couche de niobate de lithium sur silicium **300,** incluant une couche tampon **200** permettant l'accommodation du paramètre de maille entre le niobate de lithium et le substrat temporaire en silicium **100** (identiques aux étapes 1.1 à 1.3 du décrites dans le premier exemple de procédé) comme illustré en figure 3a.
Etape 3.2. :
   On procède à l'implantation d'ions Hélium et Hydrogène à travers la couche épitaxiée, de façon à former une interface I fragile à l'intérieur du substrat silicium comme illustré en figure 3b.
Etape 3.3 :
   A ce stade du procédé, on peut procéder à la formation éventuelle des électrodes et à celle d'une couche de passivation, et formation des caissons de libération **600** en couche sacrifiée, puis collage via le diélectrique **500** sur le substrat hôte **700** selon les étapes 1.4 à 1.8 du procédé précédent. Dans le cas présent le résonateur ne présente pas d'électrode inférieure sous la couche piézoélectrique, comme illustré en figure 3c.
Etape 3.4 :
   On procède au détachage du substrat temporaire de croissance **100.** Dans cet exemple on procède à un recuit permettant de provoquer la fracture du substrat de croissance au niveau de l'interface fragilisée **I** par implantation ionique. On procède ensuite à une gravure chimique de la fine couche du substrat de croissance restant attachée à la structure, puis de la couche tampon, comme illustré en figure 3d. Dans le cas d'un substrat de croissance en silicium, une solution de TMAH permet le retrait du silicium résiduel, et la gravure chimique de la couche tampon peut se faire par une solution de HCl ou de H₃PO₄ s'il s'agit de ZnO.
Etape 3.5 :
   On finalise la fabrication du composant. On procède pour cela à l'enchaînement des étapes 1.10 à 1.16 du procédé précédent, comme illustré en figure 3e qui montre le résonateur à ondes de Lamb ainsi réalisé avec un seul niveau d'électrodes **800** sur la couche **300,** une couche de diélectrique **900** et des plots de contact **1000,** sur le substrat hôte **700.**

Les exemples précédents de procédé concernent la réalisation de composants à partir de couches de niobate de lithium épitaxié.

La présente invention peut également être utilisée avec d'autres matériaux pouvant faire l'objet d'une croissance épitaxiale. On peut par exemple citer les matériaux AIN, GaN, LiTaO₃, KNbO₃, etc.

L'approche de l'invention n'est cependant en rien réduite à des couches épitaxiées. Elle peut *a priori* s'appliquer à n'importe quel type de couche déposée, dès lors que l'incorporation de l'étape de dépôt dans l'intégration complète du composant se révèle complexe (par exemple, dépôts à très haute température en présence de métaux et/ou sur une surface présentant de la topographie).

Un exemple de ce type de cas de figure est celui de l'utilisation de couches minces de PZT en vue de réaliser des micro-transformateurs piézoélectriques. Ce type de composants s'apparente aux résonateurs à ondes de Lamb décrit précédemment, mais est composé de deux transducteurs à peignes interdigités, l'un correspondant au primaire du transformateur, et l'autre au secondaire. Les ondes de plaque assurent alors le transfert de puissance du primaire au secondaire. Afin d'exciter efficacement ces ondes dans le PZT, il est nécessaire de disposer d'une électrode inférieure. Pour assurer l'isolation électrique entre primaire et secondaire, il est par conséquent nécessaire de disposer de deux électrodes inférieures distinctes, et donc de définir le niveau de métal inférieur. Or les procédés de croissance classique du PZT (par procédé sol-gel, pulvérisation cathodique ou ablation laser, ...) sont généralement optimisés pour une croissance sur un film métallique (généralement de Platine) recouvrant l'intégralité du substrat. En particulier, il a été observé que le dépôt de PZT sur électrodes définies soulève un certain nombre de problématiques : la nature de la surface sur laquelle le film de PZT est déposé est différente selon qu'il s'agisse de métal (Pt texturé) ou d'une autre sous-couche (SiO₂ amorphe ou TiO₂ partiellement texturé, ...) ; par ailleurs les coefficients de dilatation thermique des matériaux en présence sont différents. Tout ceci conduit à l'apparition de contraintes résiduelles distinctes entre les régions métallisées et celles non-métallisées. Par ailleurs, la présence de métal peut fournir une barrière à la diffusion de certains éléments (notamment le Pb). On assiste donc à l'apparition de phases parasites (phase pyrochlore déficitaire en Pb) dans les régions non métallisées, ce qui s'avère rédhibitoire en termes de fabrication et de fonctionnement des composants. Même si l'insertion de sous-couches adéquates permet de résoudre partiellement cette problématique comme décrit dans l'article : M. Bousquet, B. Viala, H. Achard, J. Georges, A. Reinhardt, E. Nolot, G. Le Rhun, E. Defaÿ, Pt-less silicon intégration of PZT sol-gel thin films for microelectronics, Electroceramics XIV, 2014, il n'en demeure qu'il est délicat d'obtenir un matériau identique entre les régions métallisées et non-métallisées.

La présente invention permet de résoudre cette problématique. En effet, elle permet de déposer un film de PZT sur un substrat de croissance disposant d'une électrode pleine plaque, puis de reporter ce film sur un substrat hôte en intégrant cette fois-ci une électrode définie. Par ailleurs, la présente invention permet d'améliorer la croissance des films de PZT en utilisant des substrats non silicium, tels que par exemple de MgO, de SrTiO₃, de LaAlO₃, de LSAT ((LaAlO₃)_{0.3}(Sr₂TaAlO₆)_{0.7}), de DyScO₃, du de Saphir (Al₂O₃) ou de niobate de lithium (LiNbO₃), tantalate de lithium (LiTaO3). Ces substrats monocristallins présentent l'avantage de permettre une croissance épitaxiale du PZT et non polycristalline comme sur la plupart des films déposés sur silicium. De plus, le choix du substrat permet de moduler l'orientation cristalline du film déposé, la structuration en domaines ferroélectriques (proportion de domaines ferroélectriques d'orientation *a*/*c*), ainsi que la température de Curie du matériau formé.

### Exemple de procédé de réalisation d'un transformateur piézoélectrique en PZT

### Etape 4.1 :

On prépare un substrat de SrTiO₃ **100** : Traitement chimique (H₂O + HF tamponné) + recuit haute température (> 1000°C) afin d'obtenir des marches atomiques (plans TiO₂ en surface) de surface, tel qu'illustré en figure 4a.

### Etape 4.2 :

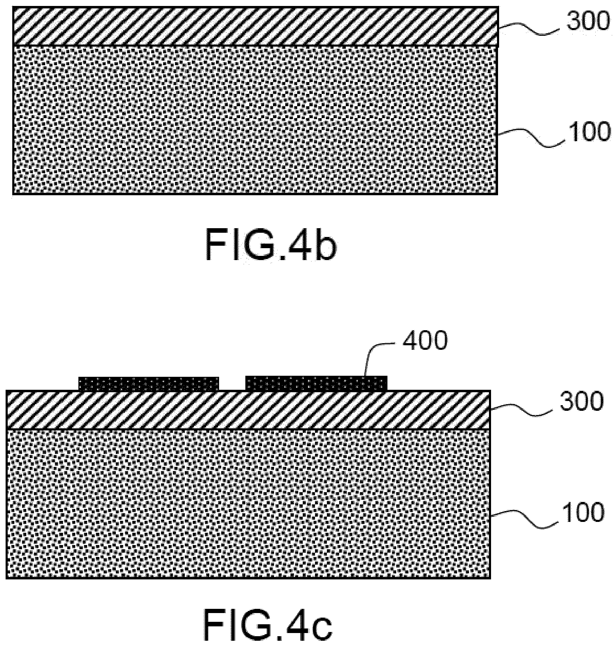

On procède au dépôt d'une couche **300** de PZT, par exemple par ablation laser, par pulvérisation cathodique ou par sol-gel, de manière préférentielle sur une épaisseur de 2 µm, comme illustré en figure 4b.

### Etape 4.3 :

On dépose une couche métallique par exemple en ruthénium de 100nm d'épaisseur, par pulvérisation, puis on procède à la structuration de cette couche pour définir des électrodes inférieures **400** par photolithographie, gravure ionique réactive et retrait de résine, comme illustré en figure 4c.

### Etape 4.4 :

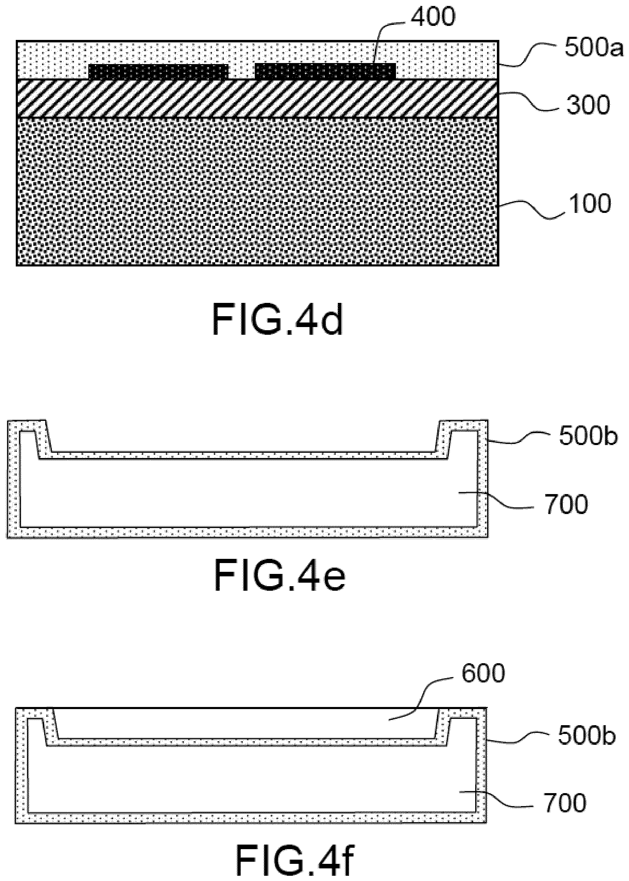

On procède au dépôt d'une couche de planarisation **500a** en SiO2 par PECVD et polissage, comme illustré en figure 4d.

### Etape 4.5 :

On procède également à des opérations de photolithographie, puis gravure ionique réactive d'un substrat de silicium hôte **700,** recouvert d'une couche d'oxyde **500b** pour définir des cavités par exemple de 3 µm de profondeur, comme illustré en figure 4e.

### Etape 4.6 :

On procède au dépôt de polysilicium sur une épaisseur de 3 µm, dans les cavités préalables définies de manière à réaliser une structure sacrifiée de polysilicium **600** puis on procède à une opération de planarisation, comme illustré en figure 4f.

### Etape 4.7 :

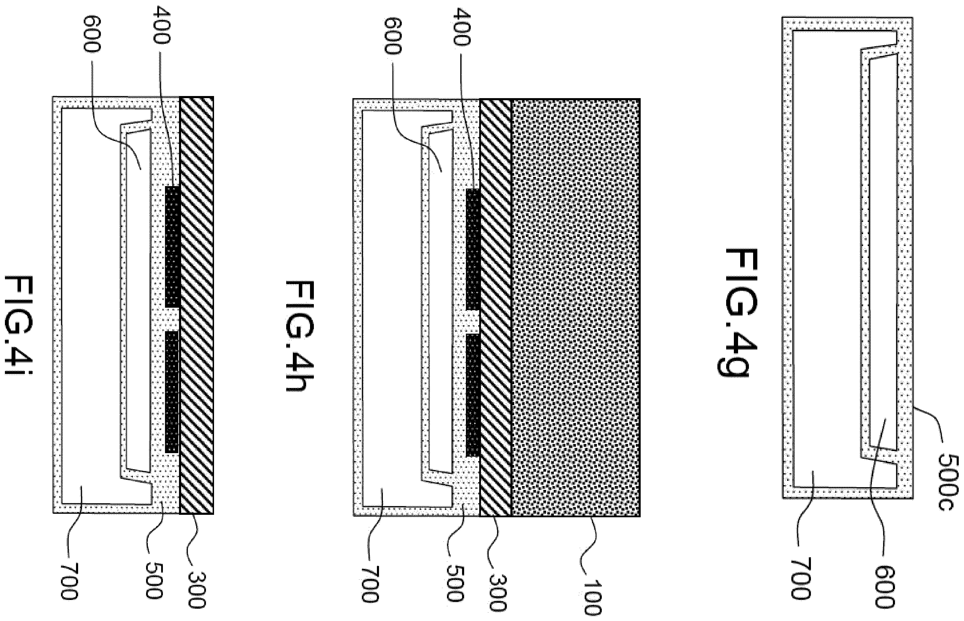

On procède à une nouvelle opération thermique sur 200nm, afin d'encapsuler la structure sacrifiée **600,** par de l'oxyde **500c,** comme illustré en figure 4g.

### Etape 4.8 :

On procède au collage du substrat temporaire de croissance **100** sur le substrat hôte **700** de silicium, avec alignement des motifs d'électrodes **400** par rapport aux caissons de polysilicium **600** comme illustré en figure 4h, puis on réalise un recuit de consolidation du substrat.

### Etape 4.9 :

On procède au retrait du substrat temporaire de croissance **100,** par amincissement mécanique et une finalisation de gravure par voie chimique, comme illustré en figure 4i.

### Etape 4.10 :

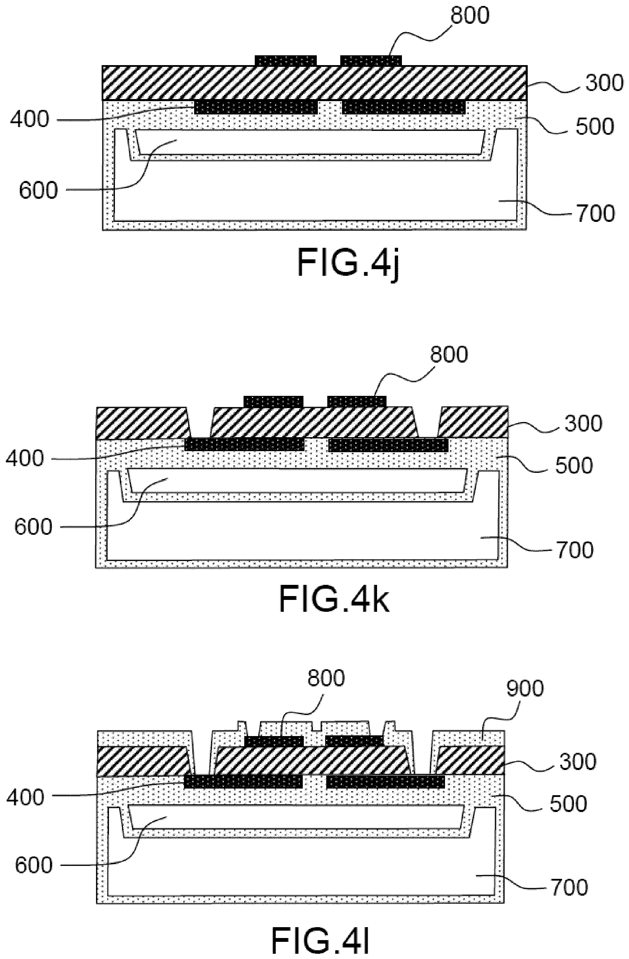

On procède au dépôt de métal constituant les électrodes supérieures, par exemple avec 100 nm de ruthénium. On réalise des opérations de photolithographie et gravure ionique puis retrait de résine, pour structurer les électrodes **800** comme illustré en figure 4j.

### Etape 4.11 :

On procède à une nouvelle opération de photolithographie, puis gravure ionique de la couche **300** de PZT pour ouvrir des contacts vers les électrodes inférieures **400** comme illustré en figure 4k.

### Etape 4.12 :

On procède au dépôt d'oxyde **900** par PECVD, par exemple sur une épaisseur de 200 nm, puis on procède à des opérations de photolithographie pour ouvrir les contacts électriques vers les électrodes inférieures **400** et supérieures **800,** comme illustré en figure 4l.

### Etape 4.13 :

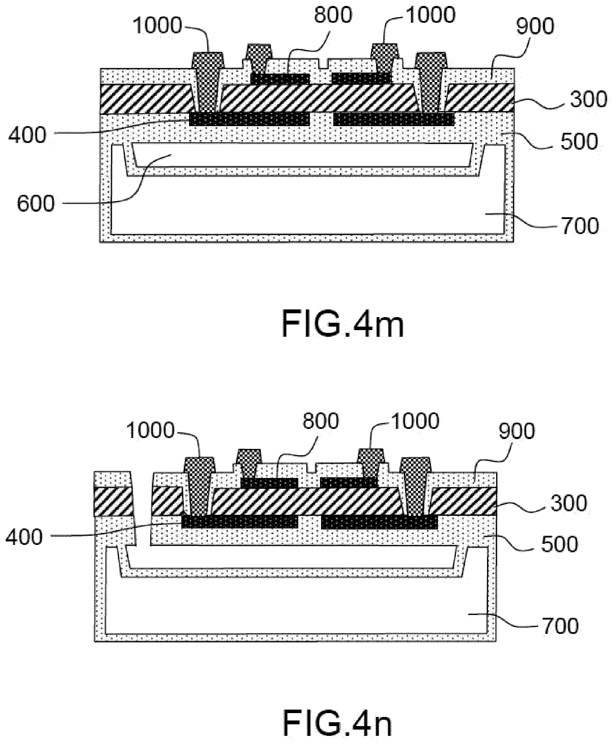

On procède au dépôt de Cr/Au (1µm) par pulvérisation, photolithographie et gravure humide, afin de former les plots de contacts électrique **1000,** comme illustré en figure 4m.

### Etape 4.14 :

On réalise à nouveau des opérations de photolithographie et gravure ionique de l'ensemble SiO₂/PZT/SiO₂ soit **500/300/900,** pour ouvrir l'accès à la structure sacrifiée de polysilicium **600.** On procède alors au retrait du polysilicium par gravure par XeF2 gazeux, comme illustré en figure 4n.

### Etape 4.15 :

On polarise le matériau ferroélectrique par application d'une tension électrique.

Ce procédé permet également d'envisager l'intégration de couches de PZT sur des substrats incompatibles avec les températures de dépôt nécessaires à l'obtention d'un film de PZT cristallisé. L'invention permet donc par exemple de réaliser des actionneurs PZT sur verre.

Enfin, la présente invention ne se limite pas nécessairement à des applications de résonateurs. Elle est déclinable à d'autres micro-systèmes tels que des actionneurs ou des capteurs.

## Revendications

1. Procédé de fabrication d'un système micro-électro-mécanique comprenant les étapes suivantes :
- la réalisation d'un empilement à la surface d'un substrat temporaire (**100**) de manière à réaliser un premier ensemble comprenant :
- au moins le dépôt d'un matériau piézoélectrique ou d'un matériau ferroélectrique pour réaliser une couche de matériau piézoélectrique ou de matériau ferroélectrique (**300**) ;
- la réalisation d'une première couche de collage (**500a, 500b**) ;
- la réalisation d'un second ensemble comprenant au moins la réalisation d'une seconde couche de collage (**500c**) à la surface d'un substrat hôte (**700**) ;
le procédé comportant en outre :
- la réalisation d'au moins une structure d'isolation acoustique dans ledit premier ensemble et la réalisation d'au moins une électrode dite inférieure (**400**) à la surface de ladite couche de matériau piézoélectrique ou de matériau ferroélectrique ;
- le collage des premier et second ensembles via la première et la seconde couches de collage, après la réalisation de l'électrode inférieure (400) et de la structure d'isolation acoustique ;
- le retrait dudit substrat temporaire (100) ;
- puis, la réalisation d'au moins une électrode dite supérieure (**800**) sur ladite couche de matériau piézoélectrique ou de matériau ferroélectrique ;
et dans lequel la réalisation de ladite au moins une structure d'isolation acoustique comprend la réalisation d'une structure de miroir de Bragg (**MR**).

2. Procédé selon la revendication 1, dans lequel le dépôt dudit matériau piézoélectrique ou dudit matériau ferroélectrique est réalisé par croissance épitaxiale.

3. Procédé selon l'une des revendications 1 à 2, dans lequel le système micro-électro-mécanique comprend au moins un résonateur à ondes élastiques de volume ou au moins un résonateur à ondes élastiques de surface ou au moins un résonateur à ondes de Lamb.

4. Procédé selon l'une des revendications 1 à 3, dans lequel le collage comprend une étape de recuit thermique.

5. Procédé selon l'une des revendications 1 à 4, dans lequel l'opération de retrait du substrat temporaire comprend :
- une étape d'amincissement dudit substrat temporaire ;
- une opération de gravure chimique dudit substrat temporaire aminci.

6. Procédé selon l'une des revendications 1 à 4, dans lequel l'opération de retrait dudit substrat temporaire comprend :
- une étape de diffusion d'éléments provoquant des précipitations ou des réactions chimiques au niveau du matériau constituant ledit substrat temporaire ou
- une étape d'implantation d'ions dans ledit substrat temporaire.

7. Procédé selon l'une des revendications 1 à 6, comprenant le dépôt d'une couche tampon (**200**) à la surface dudit substrat temporaire (**100**), préalable au dépôt dudit matériau piézoélectrique ou dudit matériau ferroélectrique.

8. Procédé selon l'une quelconque des revendications 1 à 7, comprenant la réalisation de couches structurées en métal pouvant être du Molybdène insérées dans du diélectrique pouvant être du SiO₂.

9. Procédé selon l'une quelconque des revendications 1 à 8, comportant préalablement audit collage des premier et second ensembles :
- la réalisation d'électrodes à la surface de ladite couche de matériau piézoélectrique ou de matériau ferroélectrique ;
- la réalisation d'une structure d'isolation acoustique dans ledit second ensemble.

10. Procédé selon l'une des revendications 1 à 9, dans lequel le matériau piézoélectrique est LiNbO₃ ou LiTaO₃ ou leurs solutions solides, ou KNbO₃ ou AIN, GaN.

11. Procédé selon l'une des revendications 1 à 9, dans lequel le matériau ferroélectrique est : LiNbO₃ ou LiTaO₃ ou PZT

12. Procédé selon l'une quelconque des revendications 1 à 11, dans lequel le substrat temporaire est en matériau de MgO ou de SrTiO₃ ou de LaAlO₃ ou de LSAT ((LaAlO₃)_{0.3}(Sr₂TaAlO₆)_{0.7}) ou de DyScO₃, ou de Saphir (Al₂O₃) ou de niobate de lithium (LiNbO₃), tantalate de lithium (LiTaO₃), quartz, le matériau piézoélectrique pouvant avantageusement être du PZT.

13. Procédé selon l'une quelconque des revendications 1 à 12, dans lequel la première et la seconde couches de collage sont en oxyde ou en polymère.

## Patentansprüche

1. Verfahren zur Herstellung eines mikroelektromechanischen Systems, das die folgenden Schritte umfasst:
- das Erzeugen eines Stapels auf der Oberfläche eines temporären Substrats (100), um eine erste Baugruppe herzustellen, Folgendes umfassend:
- mindestens das Abscheiden eines piezoelektrischen Materials oder eines ferroelektrischen Materials, um eine Schicht aus piezoelektrischem Material oder aus ferroelektrischem Material (300) zu erzeugen;
- das Erzeugen einer ersten Klebeschicht (500a, 500b);
- das Erzeugen einer zweiten Baugruppe, das mindestens das Erzeugen einer zweiten Klebeschicht (500c) auf der Oberfläche eines Wirtssubstrats (700) umfasst;
wobei das Verfahren ferner Folgendes aufweist:
- das Erzeugen mindestens einer schallisolierenden Struktur in der ersten Baugruppe und das Erzeugen mindestens einer sogenannten unteren Elektrode (400) auf der Oberfläche der Schicht aus piezoelektrischem Material oder aus ferroelektrischem Material;
- das Zusammenkleben der ersten und zweiten Baugruppen über die ersten und zweiten Klebeschichten, nach dem Erzeugen der unteren Elektrode (400) und der schallisolierenden Struktur;
- das Entfernen des temporären Substrats (100);
- dann das Erzeugen mindestens einer sogenannten oberen Elektrode (800) auf der Schicht aus piezoelektrischem Material oder aus ferroelektrischem Material;
und wobei das Erzeugen der mindestens einen schallisolierenden Struktur das Erzeugen einer Bragg-Spiegel- (MR-) Struktur umfasst.

2. Verfahren nach Anspruch 1, wobei das Abscheiden des piezoelektrischen Materials oder des ferroelektrischen Materials durch epitaktisches Wachstum erfolgt.

3. Verfahren nach einem der Ansprüche 1 bis 2, wobei das mikroelektromechanische System mindestens einen Resonator für elastische Volumenwellen oder mindestens einen Resonator für elastische Oberflächenwellen oder mindestens einen Resonator für Lamb-Wellen umfasst.

4. Verfahren nach einem der Ansprüche 1 bis 3, wobei das Kleben einen thermischen Glühschritt umfasst.

5. Verfahren nach einem der Ansprüche 1 bis 4, wobei der Vorgang des Entfernens des temporären Substrats Folgendes umfasst:
- einen Schritt des Ausdünnens des temporären Substrats;
- einen Vorgang des chemischen Ätzens des ausgedünnten temporären Substrats.

6. Verfahren nach einem der Ansprüche 1 bis 4, wobei der Vorgang des Entfernens des temporären Substrats Folgendes umfasst:
- einen Schritt des Diffundierens von Elementen, der Ausfällungen oder chemische Reaktionen in dem Material verursacht, aus dem das temporäre Substrat besteht, oder
- einen Schritt des Implantierens von Ionen in das temporäre Substrat.

7. Verfahren nach einem der Ansprüche 1 bis 6, das das Abscheiden einer Pufferschicht (200) auf die Oberfläche des temporären Substrats (100) vor dem Abscheiden des piezoelektrischen Materials oder des ferroelektrischen Materials umfasst.

8. Verfahren nach einem der Ansprüche 1 bis 7, umfassend das Erzeugen von Schichten, die mit Metall strukturiert sind, das Molybdän sein kann, die in das Dielektrikum eingesetzt sind, das SiO₂ sein kann.

9. Verfahren nach einem der Ansprüche 1 bis 8, das vor dem Verkleben der ersten und zweiten Baugruppen Folgendes aufweist:
- das Erzeugen von Elektroden auf der Oberfläche der Schicht aus piezoelektrischem Material oder aus ferroelektrischem Material;
- das Erzeugen einer schallisolierenden Struktur in der zweiten Baugruppe.

10. Verfahren nach einem der Ansprüche 1 bis 9, wobei das piezoelektrische Material LiNbO₃ oder LiTaO₃ oder feste Lösungen davon oder KNbO₃ oder AIN, GaN ist.

11. Verfahren nach einem der Ansprüche 1 bis 9, wobei das ferroelektrische Material Folgendes ist: LiNbO₃ oder LiTaO₃ oder PZT

12. Verfahren nach einem der Ansprüche 1 bis 11, wobei das temporäre Substrat aus einem Material aus MgO oder SrTiO₃ oder LaAlO₃ oder LSAT ((LaAlO₃)_{0,3}(Sr₂TaAlO₆)_{0,7}) oder DyScO₃ oder Saphir (Al₂O₃) oder Lithiumniobat (LiNbO₃), Lithiumtantalat (LiTaO₃), Quarz besteht, wobei das piezoelektrische Material vorteilhafterweise PZT sein kann.

13. Verfahren nach einem der Ansprüche 1 bis 12, wobei die ersten und zweiten Klebeschichten aus Oxid oder aus Polymer bestehen.

## Claims

1. A method for manufacturing a micro-electro-mechanical system, comprising the following steps:
- producing a stack on the surface of a temporary substrate (100) so as to produce a first assembly, comprising:
- at least depositing a piezoelectric material or a ferroelectric material to produce a layer of piezoelectric material or of ferroelectric material (300);
- producing a first bonding layer (500a, 500b);
- producing a second assembly comprising at least the production of a second bonding layer (500c) on the surface of a host substrate (700);
the method further containing:
- the production of at least one acoustic isolation structure in said first assembly and the production of at least one so-called lower electrode (400) on the surface of said layer of piezoelectric material or of ferroelectric material;
- the bonding of said first and second assemblies via said first and second bonding layers, after the production of the lower electrode (400) and of the acoustic isolation structure;
- the removal of said temporary substrate (100);
- then, the production of at least one so-called upper electrode (800) on said layer of piezoelectric material or of ferroelectric material;
and wherein the production of the acoustic isolation structure comprises producing a Bragg mirror (MR) structure.

2. The method according to claim 1, wherein said piezoelectric material or of said ferroelectric material is deposited by epitaxial growth.

3. The method according to one of claims 1 to 2, wherein the micro-electro-mechanical system comprises at least one volume elastic wave resonator or at least one surface elastic wave resonator or at least one Lamb wave resonator.

4. The method according to one of claims 1 to 3, wherein the bonding comprises a step of thermal annealing.

5. The method according to one of claims 1 to 4, wherein the operation of removing the temporary substrate comprises:
- a step of thinning said temporary substrate;
- an operation of chemically etching said thinned temporary substrate.

6. The method according to one of claims 1 to 4, wherein the operation of removing said temporary substrate comprises:
- a step of diffusing elements that cause precipitation or chemical reactions in the material from which said temporary substrate is made, or
- a step of implanting ions into said temporary substrate.

7. The method according to one of claims 1 to 6, comprising the deposition of a buffer layer (200) on the surface of said temporary substrate (100), prior to the deposition of said piezoelectric material or of said ferroelectric material.

8. The method according to one of claims 1 to 7, comprising the production of structured layers made of metal, that may be molybdenum, inserted into the dielectric that may be SiO₂.

9. The method according to any one of claims 1 to 8, containing, prior to said bonding of said first and second assemblies:
- the production of electrodes on the surface of said layer of piezoelectric material or of ferroelectric material;
- the production of an acoustic isolation structure in said second assembly.

10. The method according to one of claims 1 to 9, wherein the piezoelectric material is LiNbO₃ or LiTaO₃ or solid solutions thereof, or KNbO₃ or AIN, GaN.

11. The method according to one of claims 1 to 9, wherein the ferroelectric material is: LiNbO₃ or LiTaO₃ or PZT.

12. The method according to any one of claims 1 to 11, wherein the temporary substrate is made of MgO or of SrTiO₃ or of LaAlO₃ or of LSAT ((LaAlO₃)_{0.3}(Sr₂TaAlO₆)_{0.7}) or of DyScO₃, or of sapphire (Al₂O₃) or of lithium niobate (LiNbO₃), lithium tantalate (LiTaO₃), quartz, wherein the piezoelectric material can advantageously be PZT.

13. The method according to any one of claims 1 to 12, wherein the first and second bonding layers are made of oxide or made of polymer.
